# EUROPEAN PATENT SPECIFICATION

(11) **EP 2 951 808 B1**
(45) Date of publication and mention of the grant of the patent: **15.01.2020**
(21) Application number: 14745820.2
(22) Date of filing: 03.02.2014
(51) Int. Cl.: G09F 9/00, H01L 27/32, G09F 9/33, H01L 51/52

(54) **ELECTRONIC DEVICES WITH FLEXIBLE DISPLAY AND METHOD FOR MANUFACTURING THE SAME**
ELEKTRONISCHE VORRICHTUNGEN MIT EINER FLEXIBLEN ANZEIGE UND VERFAHREN ZUR HERSTELLUNG DAVON
DISPOSITIFS ÉLECTRONIQUES À ÉCRAN SOUPLE ET LEUR PROCÉDÉ DE FABRICATION

(30) Priority: 01.02.2013 US 201361760017 P; 30.01.2014 US 201414168872
(43) Date of publication of application: 09.12.2015
(73) Proprietor: LG Display Co., Ltd., SEOUL, 07336 (KR)
(72) Inventor: KWON, Se Yeoul, Goyang-si Gyeonggi-do 411-809 (KR); YOO, Juhn Suk, Goyang-si Gyeonggi-do 411-765 (KR); YANG, Jae Hun, Gyeongsan-si Gyeongsangbuk-do 712-780 (KR); YANG, Hee Seok, Ansan-si Gyeonggi-do 425-902 (KR); LEE, Chan Woo, Paju-si Gyeonggi-do 413-811 (KR); YOUN, Sang Cheon, Seoul 150-866 (KR); JO, So Young, Seoul 136-075 (KR)
(74) Representative: Ter Meer Steinmeister & Partner
(86) International application number: PCT/KR2014/000924
(87) International publication number: WO 2014/119972

(56) References cited:
- WO-A1-2014/104711
- JP-A- 2004 258 236
- JP-A- 2007 079 133
- JP-A- 2010 276 808
- KR-A- 20100 040 063
- US-A1- 2006 139 271
- US-A1- 2009 213 292
- US-A1- 2012 050 958
- US-A1- 2012 314 400

## Description

### Technical Field

### CROSS-REFERENCE TO RELATED APPLICATIONS

This application claims priority under 35 U.S.C. §119(e) to U.S. Provisional Patent Application No. 14/168,872 filed on January 30, 2014.

### BACKGROUND OF THE INVENTION

### Technical Field

This relates generally to electronic devices, and more particularly, to displays for electronic devices.

### Description of the Related Art

Electronic devices often include displays to present information for a user. Such displays are often made from rigid display structures with large non-display area to accommodate circuitry necessary for operating display pixels in a display area of the display. In some displays, the width of the non-display area reaches up to a centimeter wide or more. Such a wide non-display area tends to make displays bulky, which in turn, necessitates use of a cosmetic trim structure such as a bezel or a ring of opaque mask.

It is often desirable to maximize the display area of electronic devices without increasing the overall size of the device itself. As such, attempts are being made to reduce the size of the portion required to be covered by the bezel.

Flexible displays, which can be flexed without losing the functionality, are gaining significant attention as the next generation display technology. Flexible displays offer several advantages over the conventional rigid displays. Features offered by the flexible displays include slimmer form factor, lighter weight, increased durability, and most of all, freedom to design unique electronic devices, which could not be achieved with the rigid displays.

In a typical flexible display, an array of light-emitting diodes such as organic light-emitting diodes may form a planar active display area on a flexible substrate. Even for a flexible display, there is a minimal space requirement on the flexible substrate to accommodate circuitry and/or various other components interacting with display pixels in the display area.

US 2009/0213292 A1 discloses a flat panel display device that includes a folded bezel formed in a multi-layer structure. The flat panel display device is formed so that an electronic component of a flexible printed circuit board may be inserted into at least one opening formed at a location where the layers of the bezel correspond to one another.

US 2012/0050958 A1 discloses a housing protrusion that is interposed between a display cover layer and display components. A display is mounted on a ledge in device housing. The ledge has gaps with supports and removed corners. A support structure comprises rounded ends and a display structure is mounted on top of a flexible circuit. The flexible circuit functions as an insulating film.

US 2012/0314400 A1 discloses a flexible display extendible assembly having an extendible assembly that includes a slideable display guide integrated in a first housing part of an extendible electronic device. The extendible electronic device includes a flexible display that slide-engages into the first housing part of the extendible electronic device. The extendible assembly includes an extendible mechanism that is coupled in a second housing part of the extendible electronic device and to the slideable display guide. The first and second housing parts of the extendible electronic device slide-engage relative to each other. The extendible mechanism is implemented to extend as the first and second housing parts slide apart relative to each other, and also to retract as the first and second housing parts slide together relative to each other.

WO 2014/104711 A1 was filed before but published after the filing date of this application and discloses a flexible display device. The flexible display device comprises a first flexible substrate including a display area including an organic light emitting layer, and a peripheral circuit area, and a second flexible substrate coming in contact with the first flexible substrate and including a pattern for facilitating bending thereof, wherein the second flexible substrate has a certain shape according to the pattern, and the first flexible substrate has a shape corresponding to the certain shape. A cover serves to protect the flexible display device from external moisture, air and impact. The cover is formed of a material having a high strength and is supported by a support film. There is only empty space, such as air between the horizontal part of a support film and the vertical part of the support film.

Accordingly, a needs exist for a display structure and a method to minimize the portion of a display that needs to be covered by a cosmetic trim structure.

### BRIEF SUMMARY

The above identified objects are solved by the features of the independent claims. An electronic device may be provided that has a display such as a flexible display. Flexible displays may include organic light-emitting diode (OLED) displays on a display area of a flexible substrate. OLED displays contain display pixels that can produce illumination without using a separate backlight unit. To reduce the size of the display portion that needs to be covered by a bezel, edge portions of the flexible substrate may be bent away from the plane of the display area.

Sometimes, support films for supporting the flexible substrate may be disposed on an inner side of the flexible substrate. However, inventors of the embodiments described herein have recognized that the support films at the inner side of the flexible substrate create several undesired side effects. For instance, larger force needs to be applied to bend both the flexible substrate and the supporting film to a desired curvature. The force required to bend both the flexible substrate and the support film often result in excess mechanical stress to the bent portion of the flexible substrate. Also, the increased mechanical stress may also affect the various components on the bent portion, for example, wires and insulation layer, and generate cracks or fractures.

In addition, the flexible substrate with the support film at the bent edge portion has a tendency to return to its original flat shape. This tendency can cause the bent portion to become separated from a mounting structure to which it is adhered. The tendency to go back to the original state may also exert an undesired force on various components or structures in the electronic device.

Accordingly, an improved flexible display with a novel configuration enabling minimized bezel without the excess stress to the components is provided herein.

An aspect of the present disclosure is related to a flexible display, which facilitates to minimize bezel size in an electronic device employing the flexible display.

In an embodiment, a flexible OLED display includes a flexible substrate. The flexible substrate has a first portion where a plurality of organic light-emitting diode is disposed thereon. The flexible substrate also has a bent portion, which is curved inwardly from the plane of the first portion of the flexible substrate. There is also a second portion of the flexible substrate that extends from the bent portion and is positioned underneath the plane of the first portion of the flexible substrate. A first support film is disposed on an inner surface of the first portion of the flexible substrate. Also, a second support film that is disposed on an inner surface of the second portion of the flexible substrate. The first support film and the second support film are spaced apart from each other so that the bent portion of the flexible substrate is free of a support film. A space would be formed under the flexible substrate at the bet portion. However, an insert member is disposed between the first support film and the second support film such that a rounded end of the insert member extends towards the bent portion of the flexible substrate. Accordingly, undesired strain to the bent portion of the flexible substrate or to the circuitry on the bent portion BP of the flexible substrate from bending of the flexible substrate can be reduced.

In some embodiments, the rounded end of the insert member has a radius of curvature that is substantially equal to that of the bent portion of the flexible substrate.

In some embodiments, the rounded end of the insert member substantially fills a space under the bent portion of the flexible substrate.

In some embodiments, the insert member includes a recessed portion for receiving a chip that is operatively connected to the flexible OLED display. The chip may be operable to recognize touch signal on the flexible OLED display.

An aspect of the present disclosure relates to an electronic device with a minimized bezel.

In an embodiment, the electronic device comprises a flexible substrate having a central portion and an edge portion. A display unit is formed on the central portion of the flexible substrate. Circuitry electrically connected the display unit is disposed on the edge portion of the flexible substrate. The electrical device further includes an insert member that has a rounded end. The edge portion of the flexible substrate is configured to wrap around at least some part of the rounded end of the insert member.

The insert member may be extended towards the central portion of the flexible substrate and overlap with at least some portion of the display unit formed on the central portion of the flexible substrate.

In some embodiments, the display unit includes a plurality of organic light emitting diodes for displaying an image. The display unit may further includes a plurality of wires configured to recognize a touch input, wherein at least some of the plurality of wires is electrically connected to the circuitry on the edge portion of the flexible substrate.

In some embodiments, the edge portion of the flexible substrate may have curvature that substantially conforms to a curvature of the rounded end of the insert member.

Yet another aspect of the present disclosure relates to a method for manufacturing a flexible OLED display.

The methods includes: disposing an organic light-emitting diode on a top surface of a first portion of a flexible substrate that includes the first portion, a bending portion extended from one side of the first portion, and a second portion extended from one side of the bent portion; disposing a first support film on a bottom surface of the first portion of the flexible substrate and disposing a second support film on a bottom surface of the second portion of the flexible substrate; disposing an insert member on a bottom surface of the first support film; and bending the flexible substrate so as to allow the second portion of the flexible substrate to face at least a part of the first portion of the flexible substrate, wherein a side surface of the insert member adjacent to the bent portion of the flexible substrate is positioned on the substantially same plane as a side surface of the first support film and a side surface of the second support film which are adjacent to the bent portion of the flexible substrate and wherein the insert member protrudes with a rounded end toward the bent portion of the flexible substrate, wherein at least a part of the bent portion (BP) of the flexible substrate wraps around a surface of the rounded end of the insert member and a portion of the insert member that extends beyond the end of the first support film and the end of the second support film is thicker than a portion of the insert member covered by the first support film and/or the second support film.

It should be noted that the embodiments described in the present disclosure are not intended to be bound or otherwise be limited by any express or implied theory presented in the preceding background and brief summary. It should also be appreciated that the following detailed description is merely exemplary in nature and is not intended to limit the embodiments or the application and uses thereof. Hereinafter, exemplary embodiments will be described in detail with reference to the accompanying drawings.

### Brief Description of Drawings

FIG. 1a is a schematic cross-sectional view of a flexible organic light-emitting display for minimizing a bezel area of an electrical device.
FIG. 1b is a schematic perspective view of the flexible organic light-emitting display shown in FIG. 1a.
FIG. 2 is a schematic cross-sectional view of a flexible organic light-emitting display with an exemplary insert member with a rounded end according to an embodiment of the present disclosure.
FIG. 3 is a schematic cross-sectional view of a flexible organic light-emitting display with an exemplary insert member with a rounded end according to the present invention.
FIG. 4 is a schematic cross-sectional view of a flexible organic light-emitting display with an exemplary shape-retainer according to an embodiment of the present disclosure.
FIG. 5A is a schematic cross-sectional view of a flexible organic light-emitting display with an exemplary insert member according to an embodiment of the present disclosure.
FIG. 5b is a schematic cross-sectional view of a flexible organic light-emitting display with an exemplary insert member having a recessed portion according to an embodiment of the present disclosure.
FIG. 6 is a schematic cross-sectional view of a flexible organic light-emitting display with an exemplary step compensation layer according to an embodiment of the present disclosure.
FIG. 7 is a flowchart illustrating an exemplary method for manufacturing a flexible organic light-emitting display according to an embodiment of the present disclosure.

### DETAILED DESCRIPTION OF THE PREFERRED EMBODIMENT

Various features and advantages described in the present disclosure will be more clearly understood from the following description with reference to the accompanying drawings. Note that the accompanying drawings are merely illustrative and may not be drawn to scale for easier explanation. Also, components having the same or similar function may be denoted by the corresponding reference symbols/numerals throughout the drawings for describing various embodiments. The corresponding reference numerals, for example, 110, 210, 310 and so on indicate the same elements throughout the specification. The descriptions of the same or similar components may be omitted.

It will be understood that when an element as a layer, region or substrate is referred to as being "on" or "over" another element, it can be directly on the other element or intervening elements may also be present. In contrast, when an element is referred to as being "directly on" or "directly over" another element, there are no intervening elements present.

It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Further, it will be understood that when an element is referred to as being "overlapped" with another element, at least some portion of one element can be positioned above or below the other element. Moreover, although some of the elements are designated with numerical terms (e.g., first, second, third, etc.), it should be understood that such designations are only used to specify one element from a group of similar elements, but not to limit the element in any specific order. As such, an element designated as a first element could be termed as a second element or as third element without departing from the scope of exemplary embodiments.

Respective features of various exemplary embodiments of the present invention can be partially or totally joined or combined with each other and as sufficiently appreciated by those skilled in the art, various interworking or driving can be technologically achieved and the respective exemplary embodiments may be executed independently from each other or together executed through an association relationship. Hereinafter, various embodiments of the present invention will be described in detail with reference to the accompanying drawings.

Electronic devices may be provided with displays. The displays may include flexible display structures. In the following description, a flexible display refers to a display that can be bent without losing its functionality. For instance, some parts of a flexible display may be bent during manufacturing of a device to form a curved display and/or folded edges. Also, the flexible display may be bent and straightened during actual use of the device that includes such display. Accordingly, a flexible display should be rugged and resilient enough to withstand several types of mechanical stress during manufacturing and usage. As such, the term "flexible display" in the present disclosure encompasses a curved display, a bendable display, a rollable display, a foldable display, a twistable display, a stretchable display and the like.

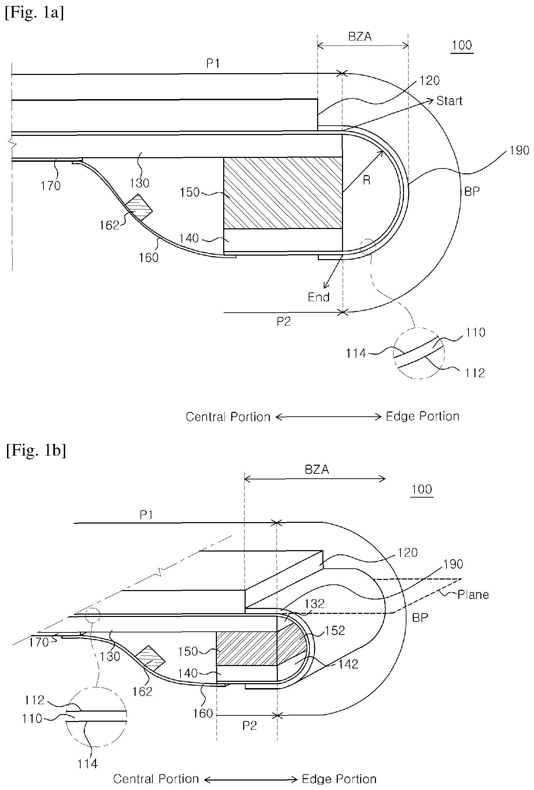

FIG. 1a illustrates a schematic cross-sectional view of an exemplary flexible organic light-emitting diode (OLED) display according to an embodiment of the present disclosure. FIG. 1b illustrates a schematic perspective view of the flexible OLED display shown in FIG. 1a.

An illustrative flexible OLED display 100 includes a flexible substrate 110. The flexible substrate 110 can be made of, for example, a polymeric material such as polyimide. Such substrates can be bent within a range of elastic deformation without generating permanent deformation up to a curvature radius of about several mm.

Several elements of the OLED display device 100 may be disposed on the flexible substrate 110. For instance, a display unit 120 is disposed on a central part of the flexible substrate 110, which may be referred to as the display area. The display unit 120 may take up the entire area of the central part or may only take a portion of the central part. Although not shown in the figures, various kinds of circuitry, for example, wires for routing signals to display pixels of the display unit 120 and/or to a touch sensor, may be disposed on the edge of the flexible substrate 110, which may be referred to as the non-display area. For various reasons, these circuitry are generally hidden from the view by covering them with a cosmetic trim, such as bezel or an opaque mask. The portion of the flexible display 100 that may be covered by such cosmetic trims is referred to as the bezel area (BZA).

In order to reduce the size of the bezel area, the edge of the flexible substrate 110 is bent. That is, the edge of flexible substrate 110 is bent downwards (inwards) away from the plane of the display area such that at least some part of the bent edge of the flexible substrate 110 lies underneath the flexible substrate 110 along the plane of the display area.

In this arrangement, the non-display area of the flexible OLED device 100 that needs to be covered by the bezel can be minimized. Any minimal non-display area that remains visible may be covered with a bezel or a portion of a display cover layer that is coated on its underside with an opaque masking layer such as black ink (as examples). A bezel may be formed, for example, from a stand-alone bezel structure that is mounted to a housing of the electronic device or to other suitable structures.

The surface of the flexible substrate 110, on which the display unit 120 is disposed thereon, is defined as the outer surface 112. The surface opposite to the outer surface 112 is defined as the inner surface 114. A support film is provided on the inner surface 114 of the flexible substrate to provide rigidity to some parts of the flexible substrate 110. More specifically, a first support film 130 is disposed on the inner surface 114 of the first portion P1 and a second support film 140 is disposed on the inner surface 114 of the second portion P2.

The insert member 150 is interposed between the first support film 130 and the second support film 140. The insert member 150 fills a space between the first support film 130 and the second support film 140, allows the radius of curvature of the bent portion BP of the flexible substrate 110 to be readily adjusted, and constantly maintains a desired radius of curvature. The insert member 150 may be made of stainless steel (SUS), polyethylene terephthalate (PET), or polycarbonate (PC), but is not limited thereto. The color of the insert member 150 may be selected to match with the color of the housing of the electronic device, in which the flexible OLED display 100 will be employed.

As shown in FIG. 1a, an insulating film 160 is connected to the second portion P2 of the flexible substrate 110 and a circuit board 170. The insulating film 160 can made of a flexible material that can be bent, and circuitry for transmitting signals to the display unit 120 may be formed on the insulating film 160. A chip 162 can be placed on the insulating film 160 as shown in FIG. 1a. The chip 162 and the insulating film 160 are sometimes collectively considered as a package, and referred to as a chip on film (COF). The chip 162 may be a driving device, which can be connected to the circuitry formed on the non-display area of the flexible substrate 110 to supply driving signal to the display unit 120. The circuit board 170 may receive an image signal from another component and supply the signals to the display unit 120 via the circuitry on the insulating film 160 and the non-display area of the flexible substrate 110. The functionality of the chip 162 and the circuit board 170 are not particularly limited, and they may provide various other functionalities, for instance audio, a touch sensing capability on the display area of the flexible OLED display 100, etc. Further, the circuit board 170 may also be made of a flexible material such as a sheet of polyimide or other type of a flexible polymer.

In FIG. 1a, the circuit board 170 is attached to a part of the inner surface of the first support film 130 rather than the insert member 150. The circuit board 170 may be affixed to the flexible substrate 110 to hold the insulating film 160, the second portion P2 of the flexible substrate 110 and the second support film 140 in place without being loosened up. Although FIG. 1a has illustrated that only the circuit board 170C is attached to the part of the bottom surface of the first support film 130, it should be noted that a part of the insulating film 160 may also be attached to another part of the bottom surface of the first support film 130 to which the circuit board 170 is not attached.

As illustrated in FIGS. 1a and 1b, the end of the first support film 130, the end of the second support film 140 and the end of the insert member 150 next to the bent portion BP are arranged to be aligned to each other with an error margin of 150 *µ*m or less. For instance, the alignment between the end of the first support film 130 and the end of the insert member 150 may be off by 150 *µ*m or less. Likewise, the alignment between the end of the second support film 140 and the end of the insert member 150 may be off by 150 *µ*m or less. Accordingly, unlike the first portion P1 and the second portion P2, the bent portion BP of the flexible substrate 110 is not supported by the support film (except for the possible error margin during the manufacturing process).

The bent portion BP of the flexible substrate 110, which is free of support film, enables bending of the flexible substrate 110 with a less amount of force than the case where the support film is disposed on the entire inner surface of the flexible substrate 110. Accordingly, undesired strain to the bent portion BP of the flexible substrate 110 or to the circuitry on the bent portion BP of the flexible substrate 110 from bending of the flexible substrate 110 can be reduced.

An adhesive layer (not shown) may be used to hold the insert member 250 in place between the first support film 130 and the second support film 140. The adhesive layer may include a pressure-sensitive adhesive, liquid adhesive, light-cured adhesive, high bond adhesive, optically clear adhesive, a foam pad (or tape) type adhesive and other suitable adhesive material. The adhesive layer may be formed on the upper surface of the insert member 150 and/or the lower surface of the insert member 150. The adhesive layer may be formed on the lower surface of the insert member 150 that does not overlap with the second support film 140.

A cover layer 190 may be formed on the outer surface of the flexible substrate 110. The cover layer 190 may be formed from a rigid or flexible transparent material such as plastic or glass. The cover layer may be substantially planar or may have a concave or convex shape. The bent portion BP of the flexible substrate 110 may be covered by the cover layer, and may further extended into the second portion P2 of the flexible substrate 110. The cover layer may be attached on the flexible substrate 110 using a suitable adhesive (e.g., optically clear adhesive, optically clear resin, etc.).

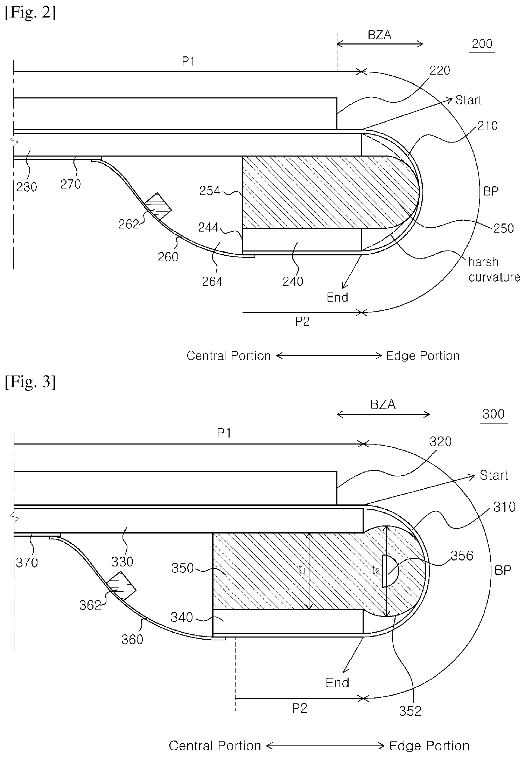

A schematic cross-sectional view of a flexible OLED display having an insert member with a rounded end is shown in FIG. 2. In the embodiment shown in FIG. 2, the end of the insert member 250 is extended out towards the bent portion BP. That is, the end of the insert member 250 is not aligned with the end of the first support film 230 or the end of the second support film 240, but the end of the insert member 250 protrudes out further towards the bent portion of the flexible substrate 210 by more than the error margin (e.g., more than 150 *µ*m).

The end of the insert member 250 has a rounded shape having a radius of curvature R and may be in contact with the flexible substrate 210 such that at least some part of the bent portion BP wraps around the surface of the rounded end of the insert member 250. The insert member 250 with a rounded end makes it easy to bend the flexible substrate 210 at the bent portion BP as the flexible substrate 210 can be bent along the surface of the rounded end of the insert member 250 with a predetermined radius of curvature. Also, the edges of the flexible OLED display 200 can be maintained to a desired shape according to the shape of rounded end of the insert member 250. Further, the insert member 250 may provide increased protection to the flexible OLED display 200 by preventing the bent portion BP of the flexible substrate 210 to be curved at an excess curvature.

The size of the bezel area BZA may depend on the radius of curvature at the bent portion BP of the flexible substrate 210, which can be controlled by the rounded end of the insert member 250. Accordingly, the radius of curvature R for the rounded end of the insert member 250 may depend on the type of electrical device in which the flexible OLED display 200 will be employed. The radius of curvature R of the rounded end of the insert member 250 may range from 0.1 mm to 10 mm, more preferably range between 0.1 mm and 5 mm, and more preferably range between 0.1 mm and 3 mm. The curvature R can also range from 0.1R to 0.5R. For mobile devices, it might be better to provide a bezel size sufficient to withstand external impact or shock that could be experienced during handling of the device by a user. On the other hand, electrical devices having rather large display (e.g., greater than 18 inches) will likely to be stationed as a location, and thus the radius of curvature R can be minimized to the extent possible to reduce the size of the bezel area BZA.

If desired, the bent portion of the flexible substrate 110 may be attached to the end of the insert member 250 by using an adhesive layer, which may include an optically clear adhesive, a pressure-sensitive adhesive, a liquid adhesive, a light-cured adhesive, a high bond adhesive foam pad adhesive or any other suitable adhesive material.

The shape of the insert member 250 in FIG. 2 is merely illustrative, and the insert member 250 can have various other shapes. Especially, the end of the insert member 250 towards the bent portion BP of the flexible substrate 210 may be differ from the exemplary insert member 250 of FIG. 2. When the rounded end of the insert member 250 has a smaller radius of curvature than the bent portion BP of the flexible substrate 210, empty space may exist between the insert member 250 and the inner surface of the flexible substrate 210 at the bent portion BP. Some parts of the bent portion BP are not supported by the rounded end of the insert member 250. In this case, the bent portion BP of the flexible substrate 210 may be bent abruptly at the edge of the first support film 230 and/or the edge of the second support film 240. An illustrative bending angle of the flexible substrate 210 is shown as the dashed line denoted as "harsh curvature" in FIG. 2. If the force used in bending the flexible substrate 210 is not controlled carefully, the flexible substrate 210 can be damaged by the edges of the upper support film 230 and the lower support film 250.

Accordingly, in the present invention, the insert member 250 may have a rounded end that can support a larger area of the bent portion BP. The portion of the insert member 250 that extends beyond the end of the first and second support films (230, 240) is thicker than the portion of the insert member 250 covered under the first and/or second support films (230, 240). The part of the insert member 250 that protrudes out may substantially fill the space formed under the flexible substrate 210 at the bent portion BP.

With the increased radius of curvature, the rounded end of the insert member 250 may fill substantially the entire inner space at the bent portion BP. This way, substantially the entire bent portion BP of the flexible substrate 210 wraps around the surface of the rounded end of the insert member 250. Since substantially the entire bent portion BP of the flexible substrate 210 is supported by the insert member 250, the mechanical stress to the flexible substrate 210 and the circuitry on the flexible substrate 210 at the bent portion BP can be reduced further. Moreover, the curvature of the flexible substrate 210 at the bent portion BP can be shaped and/or maintained by the rounded end of the insert member 250 without undesired deformation.

In some cases, the upper most edge of the rounded end at the start of the bent portion BP of the flexible substrate 110 may be too sharp and cause undesired damage to the flexible substrate 110 when it wraps around the rounded end of the insert member 150. Accordingly, some portion of the rounded end of the insert member 150 at the starting end of the bent portion BP (e.g., 0.05 mm ∼ 0.1 mm along the surface of the rounded end from the "start" of the bent portion BP) may be substantially flat along the plane of the first portion P1 of the flexible substrate 210, with a difference of less than 10 degrees, and more preferably less than 5 degrees. The lower most edge of the rounded end at the opposite end of the bent portion BP of the flexible substrate 210 may be configured in similar fashion to prevent undesired damage to the flexible substrate 210.

While the material used for the insert member 250 is not particularly limited, polymeric materials such as polycarbonate (PC) or polyethylene terephthalate (PET) may be more advantageous for more precise control of the shape in forming the insert member 250.

A schematic cross-sectional view of a flexible OLED display having an insert member made with a rounded end is shown in FIG. 3. The insert member 350 may be formed of the stainless steel (SUS). In the embodiment shown in FIG. 3, the insert member 350 includes a first portion having a first thickness t₁ and a second portion having a second thickness t₂, and the second thickness t₂ is thicker than the first thickness t₁. The first portion of the insert member 350 having the first thickness t₁ is the portion being covered by the first support film 330 and/or the second support film 340. The second portion of the insert member 350 refers to the portion of the insert member 350 that is protruded towards the bent portion BP of the flexible substrate 310 beyond the end of the first substrate 330 and the end of the second substrate 340.

At least some part of the second portion of the insert member 350 is rounded and in contact with at least some part of the bent portion BP of the flexible substrate 310. The surface 352 of the insert member 350, which is in contact with the bent portion BP, may be formed as a part of an ellipse whose major axis is equal to or longer than the second thickness t₂. The surface of the insert member 350, which is in contact with the bent portion BP, may be formed as a part of a circle whose diameter is equal to or longer than the second thickness t₂.

The increased thickness at the second portion of the insert member 350 provides increased surface area to be in contact with the bent portion BP supports a larger area of the bent portion BP of the flexible substrate 310. Thus, the curvature at the bent portion BP of the flexible substrate 310 can be maintained, such that more effective protection of the circuitry on the bent portion BP can be afforded.

Various method can be used to form the second portion of the insert member 350 to be thicker than the first portion of the insert member 350. In way of an example, a metal plate may be folded in half and the folded end may be pressed. The pressed portion bulges the folded end of the insert member 350, thereby making the second portion of the insert member 350 with the second thickness t₂. The inner space 356 of the bulged portion of the insert member 350 may serve as a cushion for reducing external impact to the flexible OLED display 300. To this end, a material that can maintain the shape at the second portion of the insert member may be positioned in the inner space 356. The inner space 356 of the bulged portion of the insert member 350 may also be used to accommodate various internal components of the flexible OLED display 300 and/or the electrical device employing the flexible OLED display 300.

In an alternative way of forming the second portion of the insert member, the metal plate may be folded in half around a major axis of a shaper (not shown). In this way, the shape and/or size of the second portion may depend on the shape and/or size of the shaper. The shaper may be removed after forming the second portion of the insert member. The inner space 356 of the second portion of the insert member 350 may be used to accommodate various internal components of the flexible OLED display 300 and/or the electrical device employing the flexible OLED display 300 (e.g., antennas, wires, speakers, touch sensors and the like).

The embodiments described above in conjunction with FIGS. 2 and 3 have utilized the insert member to serve as the structure for supporting the bent portion BP of the flexible substrate. However, a separate element other than the insert member can be utilized in supporting the bent portion BP of the flexible substrate.

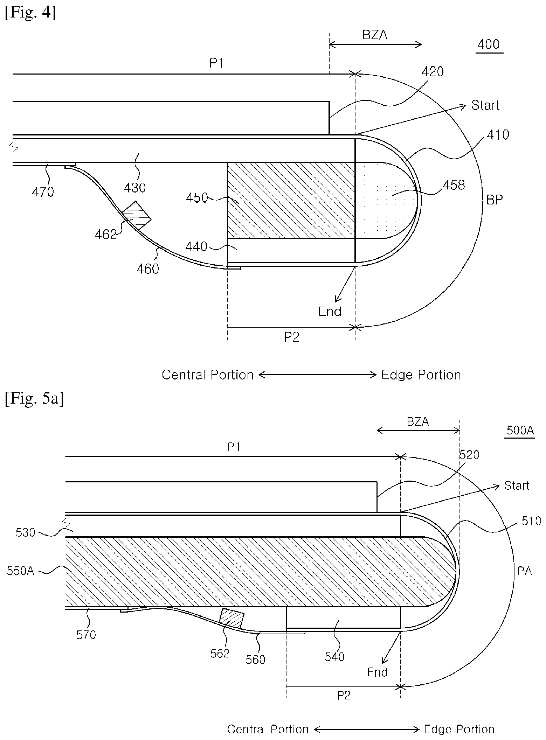

A schematic cross-sectional view of a flexible OLED display with a shape-retainer having a rounded end is shown in FIG. 4. In the embodiment of the flexible OLED display 400 depicted in FIG. 4, the shape-retainer 458, which may be made of a polymeric material such as resin or rubber, is affixed on the side surface of the insert member 450. The shape-retainer 458 is positioned next to the insert member 450, which is substantially aligned with the first (upper) support film 430 and the second (lower) support film 440, such that the rounded end of the shape-retainer 458 extends towards the bent portion BP of the flexible substrate 410.

The shape-retainer 458, with a radius of curvature R, may be in contact with the flexible substrate 110 such that at least some part of the bent portion BP of the flexible substrate 110 wraps around the surface of the rounded end of the shape-retainer 458. The rounded end of the shape-retainer 458 makes it easy to bend the flexible substrate 410 at the bent portion BP as the flexible substrate 410 can be bent along the surface of the rounded end of the shape-retainer 458 with a predetermined radius of curvature. Also, the edges of the flexible OLED display 400 can be maintained to a desired shape according to the shape of rounded end of the shape-retainer 458. Further, the shape-retainer 458 also provides increased protection (e.g., external impact) to the flexible OLED display 400 by supporting the bent portion BP of the flexible substrate 410.

The shape and size of the shape-retainer 458 in FIG. 4 is merely illustrative, and thus the shape-retainer 458 can have various shapes and sizes. When the rounded end of the shape-retainer 458 has a smaller radius of curvature than the bent portion of the flexible substrate 410, empty space may exist between the shape-retainer 458 and the inner surface of the flexible substrate 110 at the bent portion BP. Some parts of the bent portion BP are not supported by the shape-retainer 458. The bent portion BP of the flexible substrate 410 may be bent abruptly at the edge of the upper support film 430 and/or the edge of the lower support film 150 during bending of the flexible substrate 410. An illustrative bending angle of the flexible substrate 410 is shown with a dashed line in FIG. 4. If the force used in bending the flexible substrate 410 is not controlled carefully, the flexible substrate 410 can be damaged by the edges of the upper support film 430 and the lower support film 450.

Accordingly, in some embodiments, the shape-retainer 458 may have a shape that can support a larger area of the bent portion BP of the flexible substrate 410. The rounded end of the shape-retainer 458 can be thicker than the thickness of the insert member 450, and such that the shape-retainer 458 fills substantially the entire inner space at the bent portion BP. This way, substantially the entire bent portion BP of the flexible substrate 410 is wrapped around the rounded surface of the shape-retainer 458 to be supported by the shape-retainer 458. Accordingly, the mechanical stress to the flexible substrate 410 and the circuitry on the flexible substrate 410 at the bent portion BP can be reduced further. Moreover, the curvature of the flexible substrate 410 at the bent portion BP can be shaped and maintained by the rounded end of the shape-retainer 458 without undesired deformation.

The length of the insert member in the embodiments of the present disclosure may vary for a number of reasons. As mentioned above, the insert member may not be disposed over the entire flexible OLED display as it modulus of the insert member may cause undesired effect to the display unit on the flexible substrate. Accordingly, the insert member may be placed at the edges of the flexible OLED display and extends only partially into the display area of the flexible OLED display. In such a case, the end of the insert member and the end of the second support film towards the central portion of the flexible OLED display may be substantially aligned with each other. They may not be perfectly aligned with each other due to the marginal error during manufacturing of the flexible OLED display. For instance, the displacement between the end of the insert member towards central portion of the flexible OLED display 100 and the end of the second support film towards the central portion of the flexible OLED display may aligned with each other within margin of 150 *µ*m or less.

In some embodiments, the insert member may extend further into the central portion of the flexible OLED display 500A as shown in FIG. 5a. That is, the insert member 550A extends towards the central portion of the flexible OLED display 500A over the respective end of the second support film. The longer insert member 550A may overlap with some portion of the display area in the flexible OLED display 500A. For instance, the insert member 550A on one edge of the flexible OLED display 500A may extend from the bent portion BP to the central portion of the flexible OLED display 500A, such that it covers about 1/4 of the entire length of the flexible OLED display 500A.

In some embodiments, the circuit board 570 may be placed on the bottom surface of the insert member 550A. One end of the insulating film 560 is affixed on the second portion P2 of the flexible substrate 510 and the other end of the insulating film 560 is affixed on the circuit board 570 to route various signals. In this configuration, the plane level difference between the two ends of the insulating film 560 is reduced, thereby decreasing the chance of the insulating layer 560 being detached at the either ends.

It should be noted that some parts of the insulating film 560 may be attached on the bottom surface of the insert member 550A to further improve the affixation. To this end, it may be desirable to increase the contact area between the insulating film 560 and the bottom surface of the insert member 550. The surface area of the insulating film 560 that can be attached on the second surface of the insert member 550 may depend on various factors, such as the distance between the two ends that needs to be connected by the insulating film 560, the length of the insulating film 560 as well as the size of the chip 562 mounted on the insulating film 560.

Simply increasing the length of insulating film 560 add only so much as to increasing the size of the contact area. This is especially true when the distance between the circuit board 570 and the second portion P2 of the flexible substrate 510 is limited. The chip 562 mounted on the insulating film 560 further reduces the contact area.

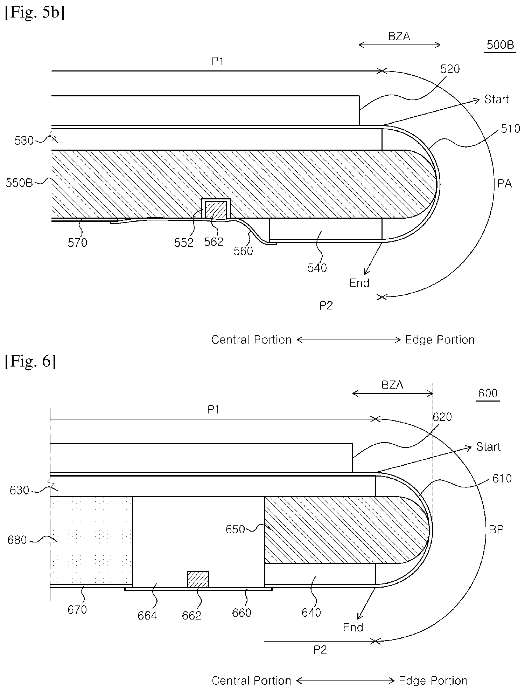

Accordingly, the insert member 550A may be provided with a recessed portion to receive the chip 562. A schematic cross-sectional view a flexible OLED display having an insert member with a recessed portion is illustrate in FIG. 5b. Referring to FIG. 5b, a recessed portion 552 is formed at the bottom surface of the insert member 550B. The recessed portion 552 of the insert member 550B may be positioned between the circuit board 170 and the second support film 540, and sized sufficiently to accommodate the chip 562 mounted on the insulating layer 560. By inserting the chip 562 in the recessed portion 552, more portion of the insulating layer 560 can be in contact with the bottom surface of the insert member 550B. Suitable adhesive layer may be applied to the portion of the insulating layer 560 that is in contact with the bottom surface of the insert member 550B. This provides more secure way of holding the insulating film 560, the chip 562 mounted on the insulating film 560 and the flexible substrate 510 in place without being loosened up.

In some embodiments, the recessed portion 552 of the insert member 550B and the chip 562 may have interlocking shapes so that the chip 562 can be interlocked within the recessed portion 552 of the insert member 550B. This can improved the affixation of the circuit board 570, the insulating layer 560 and the flexible substrate 510 to each other. An adhesive layer may not be formed between the insulating layer 560 and the bottom surface of the insert member 550B depending on the affixation strength provided by the interlocking mechanism of the chip 562 and the recessed portion 552.

While FIG. 5b illustrates that the chip 562 being positioned within the recessed portion 552. Examples of the components that may be placed within the recessed portion 552 include antennas, buttons, switches, speakers or any other components that can fit in the recessed portion 552. Such components may be mounted on an insulating film in the similar fashion as the chip 562 mounted on the insulating film 560. Also, such components may be mounted on the circuit board 570 or any other element under the insert member 550. Placing such components in the recessed portion 552 of the insert member 550B can reduce the overall size (e.g., thickness) of the electrical device. Further, in some embodiments, the recessed portion 552 may be configured to receive a securing member (not shown) to accurately position and/or to affix the flexible OLED display 500B within the electronic device.

Moreover, it should be appreciated that the number of recessed portion 552 in the insert member 552 is not particularly limited. Likewise, the sizes of the recessed portions 552 may be different from one another. In some embodiments, the insert member 552 may include more than one recessed portion 552, and each of the recessed portions 552 may be configured to receive different components and/or securing members.

In some embodiments of the flexible OLED display, the insert member may formed of a material that is difficult to form the recessed portion as described above. For example, forming a recessed portion may be more difficult in an insert member made of a metal sheet (e.g., SUS) than an insert member made of polymeric material (e.g., Polycarbonate). In such cases, a step compensation layer can be used to provide the space for receiving various components of the flexible OLED display and/or internal components of the electrical device employing the flexible OLED display.

A schematic cross-sectional view of a flexible OLED display 600 having a step compensation layer is shown in FIG. 6. Referring to FIG. 6, a step compensation layer 680 is disposed on a bottom surface of the first support film 630, and the circuit board 670 is affixed on the step compensation layer 680. The step compensation layer 680 may have a thickness that can compensate at least some of the plane level difference between the inner surface of the first support film 630 and the outer surface of the second support film 640.

The step compensation layer 680 is spaced apart from the insert member 650. Similar to the recessed portion 552 of the insert member 550B shown in FIG. 5b, the space 664 between the step compensation layer 680 and the insert member 650 may be used to accommodate various components of the flexible OLED display 600 and/or internal components of the electrical device employing the flexible OLED display 600. As such, the thickness of the step compensation layer 680 and the distance between the step compensation layer 680 and the insert member 650 may vary depending on various factors, including but not limited to, the size of the chip 662 on the insulating film 660 or other components to be inserted into the space 664. Also, it should be appreciated that multiple step compensation layer 680 can be used in the flexible OLED display 600 to provide multiple spaces 664, and each of the spaces 664 may be configured to receive different components and/or securing members.

Unlike the recessed portion 552 of the insert member 550B shown in FIG. 5b, the spaces 664 are created by the spacing between the step compensation layers 680 and the insert member 650. As such, materials for forming the step compensation layer 680 is not particularly limited. For example, the step compensation layer 680 can be made of a material such as stainless steel (SUS), polyethylene terephthalate (PET), polycarbonate (PC) or rubber.

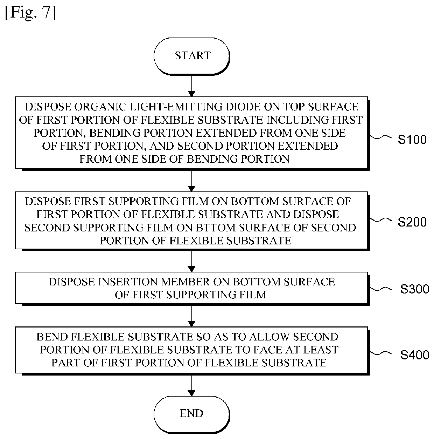

FIG. 7 is a flowchart for describing a method for manufacturing an exemplary flexible OLED display according to an embodiment of the present disclosure.

First, an organic light-emitting diode is disposed on a top surface of a first portion of a flexible substrate. (S100) The flexible substrate may be made of a material capable of being bent, that is, a material selected from a group consisting of polyester polymers, silicon polymers, acrylic polymers, polyolefin polymers, and a combination thereof,. Specifically, the flexible substrate may be made of a material selected from a ground consisting of polyethylene terephthalate (PET), poly butylene terephthalate (PBT), polysilane, polysiloxane, polysilazane, polycarbosilane, polyacrylate, polymethacrylate, polymethylacrylate, polymethylmetacrylate, polyethylacrylate, polyethylmetacrylate, cyclic olefin copolymer (COC), cyclic olefin polymer (COP), polyethylene (PE), polypropylene (PP), polyimide (PI), polymethylmethacylate (PMMA), polystyrene (PS), polyacetal (POM), polyether ether keton (PEEK), polyestersulfone (PES), polytetrafluoroethylene (PTFE), polyvinyl chloride (PVC), polycarbonate (PC), polyvilyidenefluoride (PVDF), perfluoroalkyl polymer (PVA), styrene acrylonitrile copolymer (SAN), and a combination thereof. However, the material of the flexible substrate is not limited to the aforementioned materials.

An insulating film having a chip mounted thereon may be connected to a circuit board and the second portion of the flexible substrate.

Subsequently, a first and second support film is disposed on an inner surface of the flexible substrate such that the first support film is spaced apart from the second support film. (S200) The distance between the first and second support films is substantially equal to the radius of curvature desired at the edge of the flexible OLED display.

The first support film and the second support film may be made of the substantially the same material as that of the flexible substrate. In such a case, the thicknesses of the first and second support films may be relatively thicker than that of the flexible substrate. The first support film and the second support film may be simultaneously disposed, or may be sequentially disposed.

Thereafter, an insert member is disposed on a lower surface of the first support film (S300). The insert member may be made of stainless steel (SUS), polyethylene-terephthalate (PET), or polycarbonate (PC), but is not limited thereto. The insert member may have a rounded end that is extended beyond the aligned ends of the first and second support films. The rounded end of the insert member may have greater thickness than the part of the insert member interposed between the first and the second support films.

Subsequently, the flexible substrate is bent inwards towards the back surface of the panel (i.e., bent at an angle of approximately 180 degrees). (S400) The flexible substrate can be bent along the surface of the rounded end of the insert member. When the flexible substrate is bent, a part of the first portion and the second portion of the flexible substrate are positioned to face each other, and a rounded bent portion is formed between the first portion and the second portion of the flexible substrate. The second support film disposed at the second portion of the flexible substrate is disposed on the bottom surface of the insert member. When the second support film is disposed on a part of the bottom surface of the insert member, the insulating film may be attached to another part of the bottom surface of the insert member.

A step compensation layer may be additionally disposed on the bottom surface of the first support film so as to be spaced apart from the insert member. When the step compensation layer is disposed on the bottom surface of the first support film, at least one of the insulating film and the circuit board may be attached to the step compensation layer, and the chip may be inserted into a space between the insert member and the step compensation layer.

In addition, when the second support film is disposed on a part of the bottom surface of the insert member, a recessed portion may be formed at the bottom surface of the insert member prior to bending the flexible substrate. When bending the flexible substrate, the chip may be inserted into the recessed portion formed at the bottom surface of the support film. The insulating film may be affixed on the bottom surface of the insert member using an adhesive layer.

Hereinafter, various characteristics of the flexible OLED display of the present invention will be described.

In an aspect, an embodiment of the present invention is characterized in that an insert member having a rounded end, and the rounded end has a radius of curvature that is substantially equal to that of a bent edge portion of the flexible display.

In another aspect, an embodiment of the present invention is characterized in that a rounded end of an insert member substantially fills a space at the bent edge portion of a flexible display.

In another aspect, an embodiment of the present invention is characterized in that an insert member is formed of a polymeric material.

In another aspect, an embodiment of the present invention is characterized in that an insert member includes a recessed portion configured to receive a component that is electrically connected to a flexible OLED display.

In another aspect, an embodiment of the present invention is characterized in that a component in a recessed portion of an insert member is operable to recognize a touch signal on a flexible OLED display.

In another aspect, an embodiment of the present invention is characterized in that an insert member includes a recessed portion for receiving a securing member for affixing the flexible OLED display.

In another aspect, an embodiment of the present invention is characterized in that an adhesive layer is on at least some part of an insert member of a flexible OLED display.

In another aspect, an embodiment of the present invention is characterized in that an adhesive layer interposed between an upper support film and an insert member is a foam pad type adhesive.

In another aspect, an embodiment of the present invention is characterized in that a step compensation layer is disposed on a bottom surface of the upper support film so as to be spaced apart from an insert member at the edge portion of a flexible OLED display, wherein at least one of an insulating film and a circuit board is attached to the step compensation layer.

In another aspect, an embodiment of the present invention is characterized in that a chip mounted on an insulating layer is positioned in a space between an insert member and a step compensation layer.

In another aspect, an embodiment of the present invention is characterized in that an insert member is formed of a metal sheet having a first portion with a first thickness and a second portion with a second thickness that is greater than the first thickness, and wherein the second portion of the insert member includes a channel.

In another aspect, an embodiment of the present invention is characterized in that a cover layer is formed on at least parts of an outer surface of the first portion of a flexible substrate, an outer surface of a bent portion of the flexible substrate, and an outer surface of a second portion of the flexible substrate in a flexible OLED display.

Hereinafter, various characteristics of the electronic device of the present invention will be described.

In another aspect, an embodiment of the present invention is characterized in that a display unit on a central portion of a flexible substrate includes a plurality of organic light emitting diodes for displaying an image.

In another aspect, an embodiment of the present invention is characterized in that an edge portion of the flexible substrate has a curvature that substantially conforms to a curvature of the rounded end of an insert member.

In another aspect, an embodiment of the present invention is characterized in that a display unit includes a plurality of wires configured to recognize a touch input, wherein at least some of the plurality of wires are electrically connected to the circuitry on the edge portion of the flexible substrate.

In another aspect, an embodiment of the present invention is characterized in that at least some portion of an insert member overlaps with a display unit formed on a central portion of a flexible substrate.

Hereinafter, various characteristics of the method for manufacturing a flexible OLED display of the present invention will be described.

In another aspect, an embodiment of the present invention is characterized in that the method for manufacturing a flexible OLED display comprises a step for connecting a second portion of the flexible substrate and an insulating film with a chip mounted thereon and connecting a circuit board to the insulating film, wherein the second support film is disposed on a part of a bottom surface of the insert member, and the bending of the flexible substrate includes attaching the insulating film to another part of the bottom surface of the insert member

While the present disclosure has been particularly shown and described with respect to preferred embodiments thereof, it will be understood by those skilled in the art that the foregoing and other changes in forms and details may be made without departing from the scope of the present disclosure. It is therefore intended that the present disclosure not be limited to the exact forms and details described and illustrated, but fall within the scope of the appended claims.
According to a preferred example, an electronic device comprises a flexible substrate having a central portion having a display unit and an edge portion having circuitry electrically connected the display unit; and an insert member having a rounded end, wherein the edge portion of the flexible substrate wraps around at least some part of the rounded end of the insert member. The display unit preferably further includes a plurality of organic light emitting diodes for displaying an image. The edge portion of the flexible substrate preferably has a curvature that substantially conforms to a curvature of the rounded end of the insert member. The display unit preferably further includes a plurality of wires configured to recognize a touch input, wherein at least some of the plurality of wires is electrically connected to the circuitry on the edge portion of the flexible substrate. At least some portion of the insert member preferably overlaps with the display unit formed on the central portion of the flexible substrate.

## Claims

1. A flexible OLED display, comprising: a flexible substrate (310) that includes a first portion (P1), a second portion (P2) underneath the plane of the first portion (P1) and a bent portion (BP) between the first portion (P1) and the second portion (P2); an organic light-emitting diode that is disposed on an outer surface (112) of the first portion (P1) of the flexible substrate (310); a first support film (330) that is disposed on an inner surface (114) of the first portion (P1) of the flexible substrate (310); a second support film (340) that is disposed on an inner surface (114) of the second portion (P2) of the flexible substrate (310); and an insert member (350) that is disposed between the first support film (330) and the second support film (340), wherein the insert member (350) has a rounded end that is extended towards the bent portion (BP) of the flexible substrate (310), wherein at least a part of the bent portion (BP) of the flexible substrate (310) wraps around a surface of the rounded end of the insert member (350), **characterized in that** a portion of the insert member (350) that extends beyond the end of the first support film (330) and the end of the second support film (340) is thicker than a portion of the insert member (350) covered by the first support film (330) and/or the second support film (340).

2. The flexible OLED display according to claim 1, wherein the rounded end of the insert member (350) has a radius of curvature that is equal to that of the bent portion (BP) of the flexible substrate (310).

3. The flexible OLED display according to claim 1, wherein the rounded end of the insert member (350) fills a space under the bent portion (BP) of the flexible substrate (310).

4. The flexible OLED display according to claim 1, wherein the insert member (350) is formed of a polymeric material.

5. The flexible OLED display according to claim 1, wherein the insert member (350) includes a recessed portion for receiving a chip (362) that is operatively connected to the flexible OLED display.

6. The flexible OLED display according to claim 5, wherein the chip (362) that is operable to recognize touch signal on the flexible OLED display.

7. The flexible OLED display according to claim 1, wherein the insert member (350) includes a recessed portion for receiving a securing member for affixing the flexible OLED display.

8. The flexible OLED display according to claim 1, further includes an adhesive layer on at least some part of the insert member (350).

9. The flexible OLED display according to claim 8, wherein the adhesive layer is a foam pad type adhesive layer and is interposed between the first support substrate and the insert member (350).

10. The flexible OLED display according to claim 1, further comprising: a step compensation layer that is disposed on a bottom surface of the first support film (330) so as to be spaced apart from the insert member (350), wherein at least one of the insulating film (360) and the circuit board (370) is attached to the step compensation layer.

11. The flexible OLED display according to claim 10, wherein the chip (362) is positioned in a space between the insert member (350) and the step compensation layer.

12. The flexible OLED display according to claim 1, wherein the insert member (350) is formed of a metal sheet having a first portion (P1) with a first thickness and a second portion (P2) with a second thickness, the second being greater than the first thickness, and wherein the rounded end of the insert member (350) includes a channel.

13. The flexible OLED display according to claim 1, further comprising: a cover layer (190) that is formed on at least parts of an outer surface (112) of the first portion (P1) of the flexible substrate (310), an outer surface (112) of the bent portion (BP) of the flexible substrate (310), and an outer surface (112) of the second portion (P2) of the flexible substrate (310).

14. A method for manufacturing a flexible OLED display, comprising: disposing an organic light-emitting diode on a top surface of a first portion (P1) of a flexible substrate (310) that includes the first portion (P1), a bent portion (BP) extended from one side of the first portion (P1), and a second portion (P2) extended from one side of the bent portion (BP); disposing a first support film (330) on a bottom surface of the first portion (P1) of the flexible substrate (310) and disposing a second support film (340) on a bottom surface of the second portion (P2) of the flexible substrate (310); disposing an insert member (350) on a bottom surface of the first support film (330); and bending the flexible substrate (310) so as to allow the second portion (P2) of the flexible substrate (310) to face at least a part of the first portion (P1) of the flexible substrate (310), wherein a side surface of the insert member (350) adjacent to the bent portion (BP) of the flexible substrate (310) is positioned on the same plane as a side surface of the first support film (330) and a side surface of the second support film (340) which are adjacent to the bent portion (BP) of the flexible substrate (310) and wherein the insert member protrudes with a rounded end toward the bent portion (BP) of the flexible substrate (310), wherein at least a part of the bent portion (BP) of the flexible substrate (310) wraps around a surface of the rounded end of the insert member (350), **characterized in that** a portion of the insert member (350) that extends beyond the end of the first support film (330) and the end of the second support film (340) is thicker than a portion of the insert member (350) covered by the first support film (330) and/or the second support film (340).

15. The method for manufacturing a flexible OLED display according to claim 14, further comprising: connecting the second portion (P2) of the flexible substrate (310) and an insulating film (360) on which a chip (362) is mounted; and connecting a circuit board (370) to the insulating film (360), wherein the second support film (340) is disposed on a part of a bottom surface of the insert member (350), and the bending of the flexible substrate (310) includes attaching the insulating film (360) to another part of the bottom surface of the insert member (350).

## Patentansprüche

1. Flexible OLED-Anzeige, umfassend: ein flexibles Substrat (310), das einen ersten Abschnitt (P1), einen zweiten Abschnitt (P2) unter der Ebene des ersten Abschnitts (P1) und einen gebogenen Abschnitt (BP) zwischen dem ersten Abschnitt (P1) und dem zweiten Abschnitt (P2); eine organische lichtemittierende Diode, die an einer Außenfläche (112) des ersten Abschnitts (P1) des flexiblen Substrats (310) angeordnet ist; eine erste Trägerfolie (330), die auf einer Innenfläche (114) des ersten Abschnitts (P1) des flexiblen Substrats (310) angeordnet ist; eine zweite Trägerfolie (340), die auf einer Innenfläche (114) des zweiten Abschnitts (P2) des flexiblen Substrats (310) angeordnet ist; und ein Einlageelement (350), das zwischen der ersten Trägerfolie (330) und der zweiten Trägerfolie (340) angeordnet ist, wobei das Einlageelement (350) ein abgerundetes Ende aufweist, das zum gebogenen Abschnitt (BP) des flexiblen Substrats (310) verläuft, wobei zumindest ein Teil des gebogenen Abschnitts (BP) des flexiblen Substrats (310) um eine Oberfläche des abgerundeten Endes des Einlageelements (350) gewickelt ist, **dadurch gekennzeichnet, dass** ein Abschnitt des Einlageelements (350), der über das Ende der ersten Trägerfolie (330) und das Ende der zweiten Trägerfolie (340) hinaus verläuft, dicker als ein Abschnitt des Einlageelements (350) ist, der von der ersten Trägerfolie (330) und/oder der zweiten Trägerfolie (340) abgedeckt wird.

2. Flexible OLED-Anzeige nach Anspruch 1, wobei das abgerundete Ende des Einlageelements (350) einen Krümmungsradius aufweist, der gleich dem des gebogenen Abschnitts (BP) des flexiblen Substrats (310) ist.

3. Flexible OLED-Anzeige nach Anspruch 1, wobei das abgerundete Ende des Einlageelements (350) einen Raum unter dem gebogenen Abschnitt (BP) des flexiblen Substrats (310) füllt.

4. Flexible OLED-Anzeige nach Anspruch 1, wobei das Einlageelement (350) aus einem Polymerwerkstoff gebildet ist.

5. Flexible OLED-Anzeige nach Anspruch 1, wobei das Einlageelement (350) einen vertieften Abschnitt zum Aufnehmen eines Chips (362) enthält, der mit der flexiblen OLED-Anzeige wirkverbunden ist.

6. Flexible OLED-Anzeige nach Anspruch 5, wobei der Chip (362) betreibbar ist, um ein Berührungssignal auf der flexiblen OLED-Anzeige zu erkennen.

7. Flexible OLED-Anzeige nach Anspruch 1, wobei das Einlageelement (350) einen vertieften Abschnitt zum Aufnehmen eines Sicherungselements zum Befestigen der flexiblen OLED-Anzeige enthält.

8. Flexible OLED-Anzeige nach Anspruch 1, die ferner eine Klebeschicht auf zumindest einem Teil des Einlageelements (350) enthält.

9. Flexible OLED-Anzeige nach Anspruch 8, wobei die Klebeschicht eine Klebeschicht vom Schaumstoffunterlagentyp ist und zwischen dem ersten Trägersubstrat und dem Einlageelement (350) eingefügt ist.

10. Flexible OLED-Anzeige nach Anspruch 1, ferner umfassend: eine Schrittkompensationsschicht, die auf einer Bodenfläche der ersten Trägerfolie (330) angeordnet ist, sodass sie vom Einlageelement (350) beabstandet ist, wobei zumindest eines von der Isolierfolie (360) und der Leiterplatte (370) an der Schrittkompensationsschicht befestigt ist.

11. Flexible OLED-Anzeige nach Anspruch 10, wobei der Chip (362) in einem Raum zwischen dem Einlageelement (350) und der Schrittkompensationsschicht positioniert ist.

12. Flexible OLED-Anzeige nach Anspruch 1, wobei das Einlageelement (350) aus einem Metallblech mit einem ersten Abschnitt (P1) mit einer ersten Dicke und einem zweiten Abschnitt (P2) mit einer zweiten Dicke gebildet ist, wobei die zweite größer als die erste Dicke ist und wobei das abgerundete Ende des Einlageelements (350) einen Kanal enthält.

13. Flexible OLED-Anzeige nach Anspruch 1, ferner umfassend: eine Deckschicht (190), die zumindest auf Teilen einer Außenfläche (112) des ersten Abschnitts (P1) des flexiblen Substrats (310), einer Außenfläche (112) des gebogenen Abschnitts (BP) des flexiblen Substrats (310) und einer Außenfläche (112) des zweiten Abschnitts (P2) des flexiblen Substrats (310) gebildet ist.

14. Verfahren zum Herstellen einer flexiblen OLED-Anzeige, umfassend: Anordnen einer organischen lichtemittierenden Diode auf einer Oberseite eines ersten Abschnitts (P1) eines flexiblen Substrats (310), das den ersten Abschnitt (P1), einen gebogenen Abschnitt (BP), der von einer Seite des ersten Abschnitts (P1) verläuft, und einen zweiten Abschnitt (P2) enthält, der von einer Seite des gebogenen Abschnitts (BP) verläuft; Anordnen einer ersten Trägerfolie (330) auf einer Bodenfläche des ersten Abschnitts (P1) des flexiblen Substrats (310) und Anordnen einer zweiten Trägerfolie (340) auf einer Bodenfläche des zweiten Abschnitts (P2) des flexiblen Substrats (310); Anordnen eines Einlageelements (350) auf einer Bodenfläche der ersten Trägerfolie (330); und Biegen des flexiblen Substrats (310), um zu ermöglichen, dass der zweite Abschnitt (P2) des flexiblen Substrats (310) zumindest einem Teil des ersten Abschnitts (P1) des flexiblen Substrats (310) gegenüberliegt, wobei eine Seitenfläche des Einlageelements (350) neben dem gebogenen Abschnitt (BP) des flexiblen Substrats (310) auf der gleichen Ebene wie eine Seitenfläche der ersten Trägerfolie (330) und eine Seitenfläche der zweiten Trägerfolie (340) positioniert sind, die sich neben dem gebogenen Abschnitt (BP) des flexiblen Substrats (310) befinden, und wobei das Einlageelement mit einem abgerundeten Ende zum gebogenen Abschnitt (BP) des flexiblen Substrats (310) vorsteht, wobei zumindest ein Teil des gebogenen Abschnitts (BP) des flexiblen Substrats (310) um eine Oberfläche des abgerundeten Endes des Einlageelements (350) gewickelt ist, **dadurch gekennzeichnet, dass** ein Abschnitt des Einlageelements (350), der über das Ende der ersten Trägerfolie (330) und das Ende der zweiten Trägerfolie (340) hinaus verläuft, dicker als ein Abschnitt des Einlageelements (350) ist, der von der ersten Trägerfolie (330) und/oder der zweiten Trägerfolie (340) abgedeckt wird.

15. Verfahren zum Herstellen einer flexiblen OLED-Anzeige nach Anspruch 14, ferner umfassend: Verbinden des zweiten Abschnitts (P2) des flexiblen Substrats (310) und einer Isolierfolie (360), auf der ein Chip (362) montiert ist; und Verbinden einer Leiterplatte (370) mit der Isolierfolie (360), wobei die zweite Trägerfolie (340) auf einem Teil einer Bodenfläche des Einlageelements (350) angeordnet ist und das Biegen des flexiblen Substrats ein Befestigen der Isolierfolie (360) an einem anderen Teil der Bodenfläche des Einlageelements (350) enthält.

## Revendications

1. Écran souple à OLED, comportant : un substrat souple (310) qui inclut une première portion (P1), une seconde portion (P2) sous le plan de la première portion (P1) et une portion pliée (BP) entre la première portion (P1) et la seconde portion (P2) ; une diode électroluminescente organique qui est disposée sur une surface extérieure (112) de la première portion (P1) du substrat souple (310) ; un premier film de support (330) qui est disposé sur une surface intérieure (114) de la première portion (P1) du substrat souple (310) ; un second film de support (340) qui est disposé sur une surface intérieure (114) de la seconde portion (P2) du substrat souple (310) ; et un élément d'insert (350) qui est disposé entre le premier film de support (330) et le second film de support (340),
dans lequel l'élément d'insert (350) a une extrémité arrondie qui s'étend vers la portion pliée (BP) du substrat souple (310),
dans lequel au moins une partie de la portion pliée (BP) du substrat souple (310) enveloppe une surface de l'extrémité arrondie de l'élément d'insert (350), **caractérisé en ce qu'**une portion de l'élément d'insert (350) qui s'étend au-delà de l'extrémité du premier film de support (330) et de l'extrémité du second film de support (340) est plus épaisse qu'une portion de l'élément d'insert (350) recouverte par le premier film de support (330) et/ou le second film de support (340).

2. Écran souple à OLED selon la revendication 1, dans lequel l'extrémité arrondie de l'élément d'insert (350) a un rayon de courbure qui est égal à celui de la portion pliée (BP) du substrat souple (310).

3. Écran souple à OLED selon la revendication 1, dans lequel l'extrémité arrondie de l'élément d'insert (350) remplit un espace sous la portion pliée (BP) du substrat souple (310).

4. Écran souple à OLED selon la revendication 1, dans lequel l'élément d'insert (350) est formé d'une matière polymère.

5. Écran souple à OLED selon la revendication 1, dans lequel l'élément d'insert (350) inclut une portion évidée pour recevoir une puce (362) qui est connectée de manière opérationnelle à l'écran souple à OLED.

6. Écran souple à OLED selon la revendication 5, dans lequel la puce (362) peut fonctionner pour reconnaître un signal tactile sur l'écran souple à OLED.

7. Écran souple à OLED selon la revendication 1, dans lequel l'élément d'insert (350) inclut une portion évidée pour recevoir un élément d'attache pour fixer l'écran souple à OLED.

8. Écran souple à OLED selon la revendication 1, incluant en outre une couche adhésive sur au moins une partie de l'élément d'insert (350).

9. Écran souple à OLED selon la revendication 8, dans lequel la couche adhésive est une couche adhésive de type coussinet en mousse et est intercalée entre le premier substrat de support et l'élément d'insert (350).

10. Écran souple à OLED selon la revendication 1, comportant en outre : une couche de compensation de gradin qui est disposée sur une surface inférieure du premier film de support (330) de manière à être espacée de l'élément d'insert (350), dans lequel au moins un élément parmi le film isolant (360) et la carte à circuit (370) est fixé à la couche de compensation de gradin.

11. Écran souple à OLED selon la revendication 10, dans lequel la puce (362) est positionnée dans un espace entre l'élément d'insert (350) et la couche de compensation de gradin.

12. Écran souple à OLED selon la revendication 1, dans lequel l'élément d'insert (350) est formé d'une feuille de métal ayant une première portion (P1) avec une première épaisseur et une seconde portion (P2) avec une seconde épaisseur, la seconde épaisseur étant plus grande que la première épaisseur, et dans lequel l'extrémité arrondie de l'élément d'insert (350) inclut un canal.

13. Écran souple à OLED selon la revendication 1, comportant en outre : une couche de recouvrement (190) qui est formée sur au moins des parties d'une surface extérieure (112) de la première portion (P1) du substrat souple (310), d'une surface extérieure (112) de la portion pliée (BP) du substrat souple (310) et d'une surface extérieure (112) de la seconde portion (P2) du substrat souple (310).

14. Procédé pour fabriquer un écran souple à OLED, comportant les étapes consistant à : disposer une diode électroluminescente organique sur une surface supérieure d'une première portion (P1) d'un substrat souple (310) qui inclut la première portion (P1), une portion pliée (BP) s'étendant à partir d'un côté de la première portion (P1), et une seconde portion (P2) s'étendant à partir d'un côté de la portion pliée (BP) ; disposer un premier film de support (330) sur une surface inférieure de la première portion (P1) du substrat souple (310) et disposer un second film de support (340) sur une surface inférieure de la seconde portion (P2) du substrat souple (310) ; disposer un élément d'insert (350) sur une surface inférieure du premier film de support (330) ; et plier le substrat souple (310) de manière à permettre à la seconde portion (P2) du substrat souple (310) de faire face à au moins une partie de la première portion (P1) du substrat souple (310), dans lequel une surface latérale de l'élément d'insert (350) adjacente à la portion pliée (BP) du substrat souple (310) est positionnée sur le même plan qu'une surface latérale du premier film de support (330) et qu'une surface latérale du second film de support (340) qui sont adjacentes à la portion pliée (BP) du substrat souple (310) et dans lequel l'élément d'insert fait saillie avec une extrémité arrondie vers la portion pliée (BP) du substrat souple (310),
dans lequel au moins une partie de la portion pliée (BP) du substrat souple (310) enveloppe une surface de l'extrémité arrondie de l'élément d'insert (350), **caractérisé en ce qu'**une portion de l'élément d'insert (350) qui s'étend au-delà de l'extrémité du premier film de support (330) et de l'extrémité du second film de support (340) est plus épaisse qu'une portion de l'élément d'insert (350) recouverte par le premier film de support (330) et/ou le second film de support (340).

15. Procédé pour fabriquer un écran souple à OLED selon la revendication 14, comportant en outre les étapes consistant à : connecter la seconde portion (P2) du substrat souple (310) et un film isolant (360) sur lequel une puce (362) est montée ; et connecter une carte à circuit (370) au film isolant (360), dans lequel le second film de support (340) est disposé sur une partie d'une surface inférieure de l'élément d'insert (350), et le pliage du substrat souple (310) inclut la fixation du film isolant (360) à une autre partie de la surface inférieure de l'élément d'insert (350).
